# EUROPÄISCHE PATENTSCHRIFT

(11) **EP 2 734 837 B1**
(45) Veröffentlichungstag und Bekanntmachung des Hinweises auf die Patenterteilung: **16.09.2015**
(21) Anmeldenummer: 12743940.4
(22) Anmeldetag: 18.07.2012
(51) Int. Cl.: G01N 27/90

(54) **VERFAHREN UND VORRICHTUNG ZUR ZERSTÖRUNGSFREIEN WERKSTOFFPRÜFUNG EINES PRÜFLINGS**
METHOD AND DEVICE FOR TESTING THE MATERIAL OF A TEST OBJECT IN A NONDESTRUCTIVE MANNER
PROCÉDÉ ET DISPOSITIF DE CONTRÔLE NON DESTRUCTIF DU MATÉRIAU D'UNE ÉPROUVETTE

(30) Priorität: 19.07.2011 DE 102011079438
(43) Veröffentlichungstag der Anmeldung: 28.05.2014
(73) Patentinhaber: Institut Dr. Foerster GmbH & Co. KG, 72766 Reutlingen (DE)
(72) Erfinder: HOLZMAYER, Bernhard, 72531 Hohenstein (DE); HALTER, Michael, 72793 Pfullingen (DE)
(74) Vertreter: Patentanwälte Ruff, Wilhelm, Beier, Dauster & Partner
(86) Internationale Anmeldenummer: PCT/EP2012/064057
(87) Internationale Veröffentlichungsnummer: WO 2013/011050

(56) Entgegenhaltungen:
- WO-A1-2006/007826
- US-A1- 2003 227 288
- US-A1- 2004 066 189
- US-A1- 2012 010 508
- US-B1- 6 275 781

## Beschreibung

Die Erfindung betrifft ein Verfahren und eine Vorrichtung zur zerstörungsfreien Werkstoffprüfung eines Prüflings.

Bei der zerstörungsfreien Werkstoffprüfung werden Fehler in einem Prüfling, beispielsweise in Form eines metallischen Halbzeugs, erfasst.

Bei einer Prüfverfahrensvariante wird der Prüfling mittels einer sinusförmig bestromten Sendespule mit periodischen elektromagnetischen Wechselfeldern beaufschlagt. Die dadurch in dem Prüfling induzierten Wirbelströme induzieren wiederum in einer Sonde, beispielsweise in Form einer Spule oder Spulenanordnung, ein periodisches elektrisches Signal, das eine Trägerschwingung aufweist, deren Amplitude und/oder Phase durch einen Fehler in dem Prüfling in charakteristischer Weise moduliert wird, wenn ein Fehler in einen Messbereich der Sonde gelangt.

Bei der Werkstoffprüfung kann der Prüfling relativ zu der Sonde mit einer veränderlichen Relativgeschwindigkeit bewegt werden, beispielsweise wenn der Prüfling relativ zu der Sonde beschleunigt oder abgebremst wird. Das Spektrum eines in der Sonde aufgrund eines Fehlers im Prüfling bewirkten Signals hängt von der Relativgeschwindigkeit ab, so dass üblicherweise relativgeschwindigkeitsabhängige Filtersätze für das Sondensignal erforderlich sind, was einen zusätzlichen Aufwand mit sich bringt.

Entsprechendes gilt für Prüfverfahrensvarianten, bei denen der Prüfling nicht mit einem Trägersignal beaufschlagt wird, da auch dort ein Spektrum des Sondensignals relativgeschwindigkeitsabhängig ist.

Die WO 2006/007826 A1 offenbart ein Verfahren zur zerstörungs- und berührungsfreien Erfassung von Fehlern in einem relativ zu einer Sonde mit einer veränderlichen Relativgeschwindigkeit bewegten Prüfling, bei dem der Prüfling mittels eines Senders mit periodischen elektromagnetischen Wechselfeldern beaufschlagt wird und mittels der Sonde ein periodisches elektrisches Signal erfasst wird, das eine Trägerschwingung aufweist, deren Amplitude und/oder Phase durch einen Fehler in dem Prüfling moduliert wird, wobei eine A/D-Wandlerstufe mit einem n-ten, ganzzahligen Bruchteil einer Frequenz einer Trägerschwingung getriggert wird, wobei n unter anderem in Abhängigkeit von der RelativGeschwindigkeit gewählt wird.

Der Erfindung liegt die Aufgabe zugrunde, ein Verfahren und eine Vorrichtung zur zerstörungsfreien Werkstoffprüfung eines Prüflings zur Verfügung zu stellen, die eine zuverlässige und einfach zu implementierende Werkstoffprüfung bei veränderlichen Relativgeschwindigkeiten zwischen Prüfling und Sonde ermöglichen.

Die Erfindung löst diese Aufgabe durch ein Verfahren nach Anspruch 1 und eine Vorrichtung nach Anspruch 7.

Das Verfahren zur zerstörungsfreien Werkstoffprüfung eines Prüflings, der relativ zu einer Sonde mit einer veränderlichen Relativgeschwindigkeit bewegt wird, umfasst die Schritte: Erfassen eines Sondensignals, beispielsweise eines Sondenstroms und/oder einer Sondenspannung, mittels der Sonde, Analog-Digital-Wandeln des Sondensignals zum Erzeugen eines digitalisierten Sondensignals in Form einer Folge von digitalen Worten mit einer vorgegebenen, insbesondere konstanten, Wortwiederholungsrate, n-stufiges Dezimieren der Wortwiederholungsrate des digitalisierten Sondensignals oder eines aus dem digitalisierten Sondensignal abgeleiteten digitalen Demodulationssignals mittels n kaskadierter Dezimierungsstufen, mit n ≥ 2, wobei eine jeweilige Dezimierungsstufe ein digitales Ausgangssignal mit einer, beispielsweise um eine (1) Oktave, reduzierten Wortwiederholungsrate jedoch konstanter Wortbreite ausgibt, Auswählen des Ausgangssignals einer der n Dezimierungsstufen in Abhängigkeit von der momentanen Relativgeschwindigkeit und Filtern des ausgewählten Ausgangssignals mittels eines digitalen Filters, welches mit der Wortwiederholungsrate des ausgewählten Ausgangssignals getaktet wird.

Die Realisierung von digitalen Filtern ist umso problematischer, je weiter eine Filtereckfrequenz von einer Sample- bzw. Wortwiederholungsrate entfernt ist (erforderliche Wortbreiten, Instabilitäten, etc.). Erfindungsgemäß wird daher die Wortwiederholungsrate vor der Filterung so weit wie möglich abgesenkt. Die abgesenkte Wortwiederholungsrate kann beispielsweise in etwa dem 20- bis 30-fachen der maximal auftretenden Signalfrequenz entsprechen. Bei Anwendungen mit schwankender Relativgeschwindigkeit liegt eine schwankende Signalfrequenz vor. Dieser Umstand erfordert es, die Eckfrequenzen des bzw. der Filter(s) im Betrieb an die Signalfrequenz anzupassen. Eine Änderung der Filtereckfrequenz durch Umladen von Filterkoeffizienten im laufenden Betrieb ist problematisch (Einschwingeffekte, Stabilitätsprüfung aller Koeffizientensätze, etc.). Da bei digitalen Filtern die Eckfrequenz in einem festen Verhältnis zur Sample- bzw. Wortwiederholungsrate steht, wird stattdessen erfindungsgemäß die verwendete Sample- bzw. Wortwiederholungsrate dynamisch an die momentane Signalfrequenz, d.h. Relativgeschwindigkeit, angepasst. Die Koeffizientensätze des Filters können dann unverändert bleiben.

In einer Weiterbildung umfasst das n-stufige Dezimieren der Wortwiederholungsrate die Schritte: Dezimieren der Wortwiederholungsrate in einer der Dezimierungsstufen, insbesondere der ersten Dezimierungsstufe, um einen einstellbaren Faktor k, wobei k ≥ 2, bevorzugt 20 ≤ k ≤ 40, und Dezimieren der Wortwiederholungsrate in den verbleibenden Dezimierungsstufen, insbesondere der der zweiten bis n-ten Dezimierungsstufe, jeweils um einen konstanten Faktor zwei, d.h. genau eine Oktave. Auf diese Weise kann ein großer Dynamikbereich fein gestuft durchlaufen werden. Bevorzugt wird k in Abhängigkeit von der momentanen Relativgeschwindigkeit eingestellt.

In einer Weiterbildung ist das digitale Filter ein Bandpassfilter, insbesondere mit vorgegebenen, während eines Betriebs, d.h. während der zerstörungsfreien Werkstoffprüfung des Prüflings, konstanten Filterkoeffizienten.

In einer Weiterbildung liegt die Wortwiederholungsrate des digitalisierten Sondensignals bzw. des digitalen Demodulationssignals in einem Bereich von 1 kHz bis 200 MHz, bevorzugt 2 MHz bis 6 MHz.

In einer Weiterbildung umfasst das Verfahren des Weiteren die Schritte: Beaufschlagen des Prüflings mit einem magnetischen Wechselfeld, um im Prüfling ein korrespondierendes magnetisches Wirk-Wechselfeld zu erzeugen, wobei sich das magnetische Wechselfeld mit mindestens einer vorgegeben Trägerfrequenz periodisch ändert, so dass das Sondensignal die mindestens eine Trägerfrequenz aufweist und in seiner Amplitude und/oder Phase in Abhängigkeit von Materialeigenschaften des Prüflings moduliert ist, und digitales Demodulieren des digitalisierten Sondensignals, indem das digitalisierte Sondensignal mit einem digitalisierten Trägersignal mit der mindestens einen Trägerfrequenz multipliziert wird, zum Erzeugen des digitalisierten Demodulationssignals in Form einer Folge von digitalen Worten mit der vorgegebenen Wortwiederholungsrate der Analog-Digital-Wandlung.

Die Vorrichtung ist zur Durchführung des Verfahrens ausgebildet und umfasst die Sonde, einen Analog-Digital-Wandler, der dazu ausgebildet ist, das Sondensignal zum Erzeugen des digitalisierten Sondensignals Analog-Digital-zu-Wandeln, die n kaskadierten Dezimierungsstufen, Auswahlmittel, beispielsweise eine Schaltmatrix bzw. einen Multiplexer, die dazu ausgebildet sind, das Ausgangssignal einer der n Dezimierungsstufen in Abhängigkeit von der Relativgeschwindigkeit auszuwählen, und das digitale Filter.

In einer Weiterbildung ist die Sonde eine Magnetfeldsonde, die insbesondere dazu ausgebildet ist, ein Magnetfeld induktiv oder durch Nutzung des Hall-Effekts zu erfassen.

In einer Weiterbildung sind vorgesehen: Magnetfelderzeugungsmittel, die zum Beaufschlagen des Prüflings mit dem magnetischen Wechselfeld ausgebildet sind, und ein digitaler Demodulator, der zum digitalen Demodulieren des digitalisierten Sondensignals ausgebildet ist.

Die Erfindung wird nachfolgend unter Bezugnahme auf die Zeichnung beschrieben, die bevorzugte Ausführungsformen der Erfindung darstellt. Hierbei zeigt schematisch:

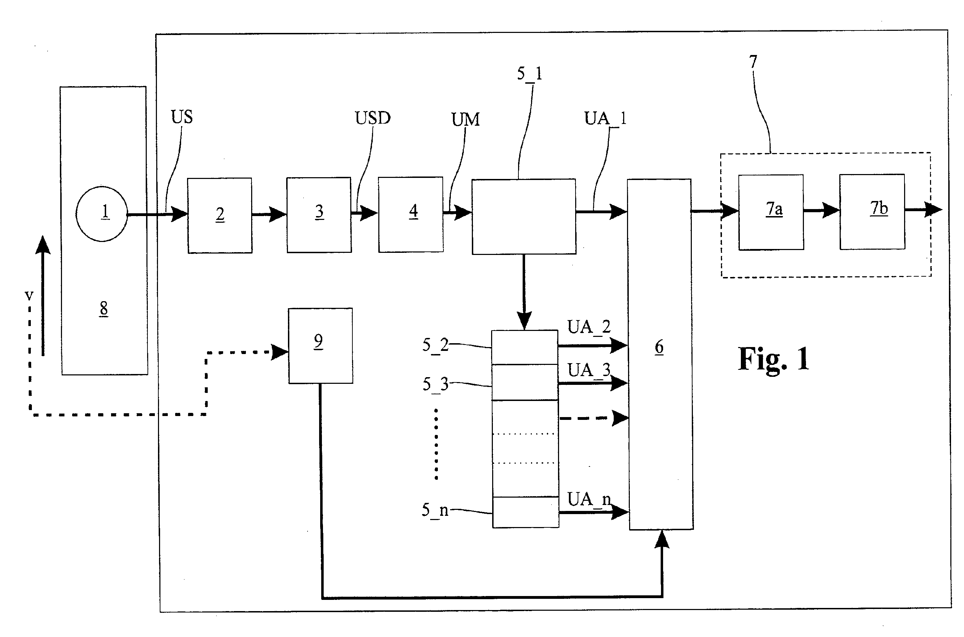

- Fig. 1: eine Vorrichtung zur zerstörungsfreien Werkstoffprüfung eines Prüflings.

Fig. 1 zeigt eine Vorrichtung zur zerstörungsfreien Werkstoffprüfung eines Prüflings 8, der relativ zu einer Magnetfeldsonde 1 mit einer veränderlichen, in der Vorrichtung bekannten Relativgeschwindigkeit bewegt wird und der mittels nicht näher dargestellter Magnetfelderzeugungsmitteln mit einem magnetischen Wechselfeld beaufschlagt wird, das mittels eines Erregersignals erzeugt wird, wobei sich das Erregersignal und somit auch das magnetische Wechselfeld mit mindestens einer vorgegeben Erreger- bzw. Trägerfrequenz periodisch ändern. Die Erreger- bzw. Trägerfrequenz kann beispielsweise in einem Bereich von 1 kHz bis 500 kHz liegen.

Dadurch wird im Prüfling ein korrespondierendes magnetisches Wirk-Wechselfeld erzeugt, so dass ein Sondensignal US die mindestens eine Trägerfrequenz aufweist und in seiner Amplitude und/oder Phase in Abhängigkeit von Materialeigenschaften des Prüflings moduliert ist.

Das Sondensignal US wird mittels eines nachgeschalteten Anti-Aliasing(AAL)-Filters 2 gefiltert und dann mittels eines Analog-Digital-Wandlers 3 zum Erzeugen eines digitalisierten Sondensignals USD in Form einer Folge von digitalen Worten mit einer vorgegebenen, konstanten Wortwiederholungsrate und einer vorgegebenen, konstanten Wortbreite Analog-Digital-gewandelt. Das Sondensignal US ist folglich mit einer konstanten Wortwiederholungsrate bzw. Sample-Rate zeit- und amplitudendiskret digitalisiert. Die Wortwiederholungsrate wird durch den Analog-Digital-Wandler 3 bestimmt und beträgt exemplarisch 4MSample/s. Der Analog-Digital-Wandler 3 und die Vorbeschaltung in Form des Anti-Aliasing-Filters 2 sorgen für die Einhaltung des Shannon-Theorems, d.h. das Eingangssignal des Analog-Digital-Wandlers 3 enthält nur Frequenzanteile < 2MHz.

Ein digitaler Demodulator 4 dient zum digitalen Demodulieren des digitalisierten Sondensignals USD, indem das digitalisierte Sondensignal USD mit einem nicht näher dargestellten digitalisierten Trägersignal mit der mindestens einen Trägerfrequenz multipliziert wird, um auf diese Weise ein digitalisiertes Demodulationssignal UM in Form einer Folge von digitalen Worten mit der vorgegebenen Wortwiederholungsrate zu erzeugen. Die Demodulation erfolgt phasenstarr mit dem Erregersignal, damit die Phasenverschiebung zwischen Erregersignal und Sondensignal US ermittelt werden kann, die Prüfinformationen enthält. Die Demodulation erfolgt durch eine Multiplikation mit dem Erregersignal unter Beibehaltung der vollen Wortwiederholungsrate des Analog-Digital-Wandlers 3.

Die Demodulation kann zweimal ausgeführt werden, nämlich einerseits als Multiplikation mit einem Cosinussignal mit der Trägerfrequenz zur Erzeugung einer X-Komponente und als Multiplikation mit einem Sinussignal mit der Trägerfrequenz zur Erzeugung einer Y-Komponente. Bei diesen Multiplikationen entstehen die Summe und die Differenz des vorliegenden Spektrums mit der Trägerfrequenz. Die Weiterverarbeitung der beiden demodulierten Komponenten erfolgt in jeweils identischer Weise, wobei nachfolgend die Weiterverarbeitung exemplarisch lediglich für eine Komponente beschrieben ist.

Herkömmlich erfolgt die Demodulation durch 1 bzw. 2 Abtastungen bzw. Samples pro Trägerperiode bei festen Phasenwinkeln. In diesem Fall bedeutet die Demodulation gleichzeitig ein Sampling mit der Trägerfrequenz bzw. der doppelten Trägerfrequenz. Um Störungen durch Aliasing-Produkte zu vermeiden, müssen vor dieser Demodulation Frequenzbereiche bei 0Hz und um die Trägerfrequenz und ihre Vielfachen mit einem Anti-Aliasing-Filter unterdrückt werden.

Erfindungsgemäß erfolgt die Demodulation mit der vollen, konstanten Wortwiederholungsrate des Analog-Digital-Wandlers 3, so dass die Demodulation unabhängig von der Erreger- bzw. Trägerfrequenz ist. Dadurch reduziert sich ein analoger Schaltungsaufwand vor dem Analog-Digital-Wandler 3 auf ein Minimum, nämlich ein konstantes AAL-Tiefpassfilter bei der halben Wortwiederholungsrate bzw. Wortwiederholungsfrequenz des Analog-Digital-Wandlers 3. Dadurch, dass die Wortwiederholungsrate vor und bei der Demodulation nicht reduziert wird, ist kein AAL-Filter vor der Demodulation notwendig.

Ein Dezimator mit n kaskadierten Dezimierungsstufen 5_1 bis 5_n dient zum n-stufigen Dezimieren der Wortwiederholungsrate des digitalen Demodulationssignals UM, wobei Ausgänge der jeweiligen Dezimierungsstufen 5_1 bis 5_n mit korrespondierenden Eingängen eines Auswahlmittels in Form einer Schaltmatrix 6 verbunden sind. Die Anzahl n der Dezimierungsstufen kann beispielsweise 13 betragen.

Im Demodulator 4 oder nachgeschaltet ist ein nicht gezeigtes Tiefpassfilter vorgesehen, welches derart dimensioniert ist, dass Demodulations-Nebenprodukte bei der doppelten Trägerfrequenz hinreichend unterdrückt werden. Gleichzeitig dient das Filter als AAL-Filter vor der Dezimierung der Wortwiederholungsrate.

Ein Ausgang der Schaltmatrix 6 ist mit einem digitalen Bandpassfilter 7 als Applikationsfilter verbunden, wobei die Schaltmatrix 6 eine Dezimierungsstufe in Abhängigkeit von der momentanen Relativgeschwindigkeit auswählt, die der Schaltmatrix 6 von einer Geschwindigkeitsmessvorrichtung 9 zur Verfügung gestellt wird. Das mittels der Schaltmatrix 6 ausgewählte Ausgangssignal dient als Eingangssignal für das Bandpassfilter 7, das mit der entsprechend reduzierten Wortwiederholungsrate des ausgewählten Ausgangssignals getaktet wird.

Aufgrund der relativgeschwindigkeitsabhängigen Taktung des Bandpassfilters 7 ergeben sich dessen Eckfrequenzen automatisch passend zur momentanen Relativgeschwindigkeit, so dass das relativgeschwindigkeitsabhängige Spektrum des in der Sonde 1 erzeugten Signals automatisch berücksichtigt wird, ohne dass hierzu, wie herkömmlich, relativgeschwindigkeitsabhängige Filtersätze erforderlich wären.

Das Bandpass bzw. Applikationsfilter 7, umfassend einen Tiefpass 7a und einen Hochpass 7b, dient im Wesentlichen zur applikationsspezifischen Störunterdrückung. Zu filternde Störungen ergeben sich hauptsächlich aus dem Prüfmaterial, beispielsweise aufgrund von Gefügeänderungen, Permeabilitätsschwankungen, Oberflächenrauhigkeit, etc. Hierfür ist der Hochpass 7b bedeutsam. Der Tiefpass 7a dient zur niederfrequenten Störunterdrückung, beispielsweise zur Unterdrückung von Netzbrumm etc.

Der Durchlassbereich des Applikationsfilters 7 entspricht den Frequenzen der unterschiedlichen aufzufindenden Materialfehler bei gegebener Spurgeschwindigkeit (schmaler Riss senkrecht überfahren bis breiter Riss schräg überfahren). An einem Ausgang des Applikationsfilters 7 wird ein entsprechend bandpassgefiltertes Demodulationssignal ausgegeben, welches beispielsweise, gegebenenfalls nach einer weiteren Wortwiederholungsratenreduktion, in einem Mikroprozessor und/oder dedizierter Hardware zur Fehlererkennung im Prüfling ausgewertet werden kann.

Bei Applikationen mit schwankender Spur- bzw. Relativgeschwindigkeit liegt eine schwankende Signalfrequenz vor. Dieser Umstand erfordert es, die Eckfrequenzen des oder der Applikationsfilter im Betrieb an die Signalfrequenz anzupassen. Eine Änderung der Filtereckfrequenz durch Umladen der Koeffizienten im laufenden Betrieb ist jedoch problematisch (Einschwingeffekte, Stabilitätsprüfung aller Koeffizientensätze, usw.). Da jedoch bei digitalen Filtern die Eckfrequenz in einem festen Verhältnis zur Taktfrequenz, d.h. Wortwiderholungsrate, steht, wird stattdessen die Taktfrequenz dynamisch an die Signalfrequenz angepasst. Die Koeffizientensätze des Applikationsfilters 7 können dann während des Betriebs unverändert bleiben.

Abhängig von den vorkommenden Materialfehlern einerseits und dem Störsignalaufkommen andererseits muss die Bandbreite einstellbar sein. Während der Tiefpass 7a des Applikationsfilters 7 immer mit dem gleichen Koeffizientensatz betrieben wird, können für den Hochpass 7b des Applikationsfilters 7 mehrere anwendungsspezifische Koeffizientensätze bereit gehalten werden, die in einer Einrichtphase von einem Bediener anwendungsspezifisch ausgewählt werden können. Während des Betriebs der Prüfvorrichtung ist es jedoch nicht notwendig, einen Koeffizientensatz zu verändern.

Die Realisierung des Applikationsfilters 7 ist umso komplexer, je weiter eine Filtereckfrequenz von der Taktfrequenz des Applikationsfilters 7 entfernt ist. Aufgrund des Dezimators wird diesbezüglich immer eine optimierte Taktfrequenz, d.h. Wortwiederholungsrate, zur Verfügung gestellt. Die Wortwiederholungsrate kann mittels des Dezimators beispielsweise bis auf das 24-fache der maximal zu erwartenden Signalfrequenz dezimiert werden.

Das Dezimieren wird nicht in einem Schritt durchgeführt, sondern geteilt in eine erste Dezimierungsstufe 5_1, die die Wortwiederholungsrate-Rate innerhalb einer Oktave variiert, und Dezimierungsstufen 5_2 bis 5_n, die in einer Kette die Wortwiederholungsrate jeweils halbieren.

Die Kette der Dezimierungs- bzw. Halbierungsstufen 5_2 bis 5_n stellt nach jeder Stufe einen Abgriff bereit. Das bedeutet, die Signale stehen in vielen Erfassungsfrequenzen in Oktavschritten gleichzeitig zur Verfügung. Bei Änderungen der Signalfrequenz kann mittels der Schaltmatrix 6 auf einen anderen, zugehörigen Abgriff gewechselt werden. Der Dynamikbereich, über den gewechselt werden kann, kann durch Verlängern der Kette der Halbierungsstufen 5_2 bis 5_n prinzipiell beliebig groß werden.

Jede der Dezimierungsstufen 5_1 bis 5_n weist ein nicht gezeigtes Dezimierungsfilter mit geringem Abstand zwischen Eckfrequenz und zugehöriger Wortwiederholungsrate auf, so dass die Dezimierungsfilter einfach und stabil realisierbar sind.

Die erste Dezimierungsstufe 5_1 senkt von der Wortwiederholungsrate des Analog-Digital-Wandlers 3 bis auf die höchste benötigte Erfassungsfrequenz ab mit einer über eine Oktave variierbaren Dezimationsrate k, mit k beispielsweise 20, 21, 22 ... 40. Die Ratenreduktion kann beispielsweise dadurch erzeugt werden, dass nach einem Sample die nächsten k-1 Samples entfernt werden. Mittels der ersten Dezimierungsstufe 5_1 kann die Wortwiederholungsrate beispielsweise in 20 Stufen über eine Oktave variiert werden mit einer Schrittweite <= 5%.

Eine Variation von k erfolgt in Anpassung an die Signalfrequenz, die wiederum über die Relativgeschwindigkeit erfasst wird. Bei schwankender Relativgeschwindigkeit werden regelmäßig Geschwindigkeitsmesswerte erfasst, und die Ratenreduktion k wird dynamisch im Betrieb mitgeführt.

Die Variationsbreite der Wortwiederholungsrate wird über eine Oktave hinaus mittels der Dezimierungsstufen 5_2 bis 5_n bis zur niedrigsten benötigten Wortwiederholungsrate erweitert. Die Ratenreduktion um den Faktor 2 entsteht durch Weglassen jedes zweiten Samples.

Die Kette der Dezimierungsstufen 5_2 bis 5_n wird immer über die volle Länge entsprechend der minimalen Signalfrequenz betrieben. Nach jeder Halbierungsstufe kann der Abgriff für die Weiterverarbeitung des Prüfsignals erfolgen. Der Dezimator selbst bleibt dabei immer unverändert.

Es versteht sich, dass im Falle von unmodulierten Sondensignalen auf den Demodulator verzichtet werden kann.

Die gezeigten Ausführungsformen ermöglichen eine zuverlässige und einfach zu implementierende Werkstoffprüfung bei veränderlichen Relativgeschwindigkeiten zwischen Prüfling und Sonde.

## Patentansprüche

1. Verfahren zur zerstörungsfreien Werkstoffprüfung eines Prüflings (8), der relativ zu einer Sonde (1) mit einer veränderlichen Relativgeschwindigkeit bewegt wird, mit den Schritten:
- Erfassen eines Sondensignals (US) mittels der Sonde (1),
- Analog-Digital-Wandeln des Sondensignals (US) zum Erzeugen eines digitalisierten Sondensignals (USD) in Form einer Folge von digitalen Worten mit einer vorgegebenen, insbesondere konstanten, Wortwiederholungsrate,
- n-stufiges Dezimieren der Wortwiederholungsrate des digitalisierten Sondensignals (USD) oder eines aus dem digitalisierten Sondensignal abgeleiteten digitalen Demodulationssignals (UM) mittels n kaskadierter Dezimierungsstufen (5_1 bis 5_n), mit n ≥ 2,
- Auswählen eines Ausgangssignals (UA_1 bis UA_n) einer der n Dezimierungsstufen (5_1 bis 5_n) in Abhängigkeit von der momentanen Relativgeschwindigkeit und
- Filtern des ausgewählten Ausgangssignals mittels eines digitalen Filters (7), welches mit der Wortwiederholungsrate des ausgewählten Ausgangssignals getaktet wird.

2. Verfahren nach Anspruch 1, **dadurch gekennzeichnet, dass** das n-stufige Dezimieren der Wortwiederholungsrate die Schritte umfasst:
- Dezimieren der Wortwiederholungsrate in einer der Dezimierungsstufen, insbesondere der ersten Dezimierungsstufe (5_1), um einen einstellbaren Faktor k, wobei k ≥ 2, bevorzugt 20 ≤ k ≤ 40, und
- Dezimieren der Wortwiederholungsrate in den verbleibenden Dezimierungsstufen, insbesondere der der zweiten bis n-ten Dezimierungsstufe (5_2 bis 5_n), jeweils um einen konstanten Faktor zwei.

3. Verfahren nach Anspruch 2, **dadurch gekennzeichnet, dass** k in Abhängigkeit von der momentanen Relativgeschwindigkeit eingestellt wird.

4. Verfahren nach einem der vorhergehenden Ansprüche, **dadurch gekennzeichnet, dass**
- das digitale Filter (7) ein Bandpassfilter ist, insbesondere mit im Betrieb vorgegebenen, konstanten Filterkoeffizienten.

5. Verfahren nach einem der vorhergehenden Ansprüche, **dadurch gekennzeichnet, dass**
- die Wortwiederholungsrate des digitalisierten Sondensignals bzw. des digitalen Demodulationssignals in einem Bereich von 1 kHz bis 200 MHz, insbesondere 2 MHz bis 6 MHz, liegt.

6. Verfahren nach einem der vorhergehenden Ansprüche, **gekennzeichnet durch** die Schritte:
- Beaufschlagen des Prüflings (8) mit einem magnetischen Wechselfeld, um im Prüfling (8) ein korrespondierendes magnetisches Wirk-Wechselfeld zu erzeugen, wobei sich das magnetische Wechselfeld mit mindestens einer vorgegeben Trägerfrequenz periodisch ändert, so dass das Sondensignal (US) die mindestens eine Trägerfrequenz aufweist und in seiner Amplitude und/oder Phase in Abhängigkeit von Materialeigenschaften des Prüflings moduliert ist, und
- digitales Demodulieren des digitalisierten Sondensignals (USD), indem das digitalisierte Sondensignal (USD) mit einem digitalisierten Trägersignal mit der mindestens einen Trägerfrequenz multipliziert wird, zum Erzeugen des digitalisierten Demodulationssignals (UM) in Form einer Folge von digitalen Worten mit der vorgegebenen Wortwiederholungsrate.

7. Vorrichtung zur Durchführung des Verfahrens nach einem der Ansprüche 1 bis 6, **gekennzeichnet durch**
- die Sonde (1),
- einen Analog-Digital-Wandler (3), der dazu ausgebildet ist, das Sondensignal (US) zum Erzeugen des digitalisierten Sondensignals Analog-Digital-zu-Wandeln,
- die n kaskadierten Dezimierungsstufen (5_1 bis 5_n),
- Auswahlmittel (6), die dazu ausgebildet sind, das Ausgangssignal (UA1 bis UA_n) einer der n Dezimierungsstufen (5_1 bis 5_n) in Abhängigkeit von der Relativgeschwindigkeit auszuwählen, und
- das digitale Filter (7).

8. Vorrichtung nach Anspruch 7, **dadurch gekennzeichnet, dass**
- die Sonde (1) eine Magnetfeldsonde ist, die insbesondere dazu ausgebildet ist, ein Magnetfeld induktiv oder durch Nutzung des Hall-Effekts zu erfassen.

9. Vorrichtung nach Anspruch 7 oder 8, **gekennzeichnet durch**
- Magnetfelderzeugungsmittel, die zum Beaufschlagen des Prüflings mit dem magnetischen Wechselfeld ausgebildet sind, und
- einen digitalen Demodulator (4), der zum digitalen Demodulieren des digitalisierten Sondensignals ausgebildet ist.

## Claims

1. A method for testing the material of a test object (8) in a nondestructive manner, said test object being moved relative to a probe (1) at a variable relative speed, comprising the steps:
- detecting a probe signal (US) by means of the probe (1),
- subjecting the probe signal (US) to analog-to-digital conversion in order to generate a digitized probe signal (USD) in the form of a sequence of digital words with a predefined, in particular constant, word repetition rate,
- n-stage decimation of the word repetition rate of the digitized probe signal (USD) or of a digital demodulation signal (UM) derived from the digitized probe signal, wherein the n-stage decimation is performed by means of n cascaded decimation stages (5_1 to 5_n), where n ≥ 2,
- selecting an output signal (UA_1 to UA_n) of one of the n decimation stages (5_1 to 5_n) depending on the instantaneous relative speed, and
- filtering the selected output signal by means of a digital filter (7), which is clocked with the word repetition rate of the selected output signal.

2. The method according to claim 1, **characterized in that** the n-stage decimation of the word repetition rate comprises the steps:
- decimating the word repetition rate in one of the decimation stages, in particular the first decimation stage (5_1), by a settable factor k, where k ≥ 2, preferably 20 ≤ k ≤ 40, and
- decimating the word repetition rate in the remaining decimation stages, in particular the second to n-th decimation states (5_2 to 5_n), by a constant factor of two.

3. The method according to claim 2, **characterized in that** k is set depending on the instantaneous relative speed.

4. The method according to any one of the preceding claims, **characterized in that**
- the digital filter (7) is a bandpass filter, in particular having constant filter coefficients that are predefined during operation.

5. The method according to any one of the preceding claims, **characterized in that**
- the word repetition rate of the digitized probe signal or of the digital demodulation signal lies in a range of 1 kHz to 200 MHz, in particular 2 MHz to 6 MHz.

6. The method according to any one of the preceding claims, **characterized by** the steps:
- applying an alternating magnetic field to the test object (8) in order to generate a corresponding effective alternating magnetic field in the test object (8), the alternating magnetic field changing periodically with at least one predefined carrier frequency, such that the probe signal (US) has the at least one carrier frequency and is modulated in terms of its amplitude and/or phase depending on material properties of the test object, and
- digitally demodulating the digitized probe signal (USD) by multiplying the digitized probe signal (USD) by a digitized carrier signal having the at least one carrier frequency, in order to generate the digitized demodulation signal (UM) in the form of a sequence of digital words having the predefined word repetition rate.

7. A device for carrying out the method according to any one of claims 1 to 6, **characterized by**
- the probe (1),
- an analog-to-digital converter (3) designed for subjecting the probe signal (US) to analog-to-digital conversion in order to generate the digitized probe signal,
- the n cascaded decimation stages (5_1 to 5_n),
- selection means (6) designed for selecting the output signal (UA_1 to UA_n) of one of the n decimation stages (5_1 to 5_n) depending on the relative speed, and
- the digital filter (7).

8. The device according to claim 7, **characterized in that**
- the probe (1) is a magnetic field probe designed, in particular, for detecting a magnetic field inductively or by using the Hall effect.

9. The device according to claim 7 or 8, **characterized by**
- magnetic field generating means designed for applying the alternating magnetic field to the test object, and
- a digital demodulator (4) designed for digitally demodulating the digitized probe signal.

## Revendications

1. Procédé pour le contrôle non destructif du matériau d'un échantillon (8) qui est déplacé par rapport à une sonde (1) avec une vitesse relative variable, avec les étapes suivantes :
- la détection d'un signal de sonde (US) au moyen de la sonde (1),
- la conversion analogique-numérique du signal de sonde (US) pour générer un signal de sonde numérisé (USD) sous la forme d'une séquence de mots numériques avec un taux de répétition de mots prescrit, en particulier constant,
- la décimation en n étapes du taux de répétition de mots du signal de sonde numérisé (USD) ou d'un signal de démodulation numérique (UM) dérivé du signal de sonde numérisé au moyen de n étapes de décimation en cascade (5_1 à 5_n), avec n ≥ 2,
- la sélection d'un signal de sortie (UA_1 à UA_n) de l'une des n étapes de décimation (5_1 à 5_n) en fonction de la vitesse relative momentanée, et
- le filtrage du signal de sortie sélectionné au moyen d'un filtre numérique (7), lequel est cadencé avec le taux de répétition de mots du signal de sortie sélectionné.

2. Procédé selon la revendication 1, **caractérisé en ce que** la décimation en n étapes du taux de répétition de mots comprend les étapes suivantes :
- la décimation du taux de répétition de mots dans l'une des étapes de décimation, en particulier la première étape de décimation (5_1), de l'ordre d'un facteur k réglable, avec k ≥ 2, de préférence 20 ≤ k ≤ 40, et
- la décimation du taux de répétition de mots dans les étapes de décimation restantes, en particulier les deuxième à n-ème étapes de décimation (5_2 à 5_n), respectivement de l'ordre d'un facteur deux constant.

3. Procédé selon la revendication 2, **caractérisé en ce que** k est réglé en fonction de la vitesse relative momentanée.

4. Procédé selon l'une des revendications précédentes, **caractérisé en ce que**
- le filtre numérique (7) est un filtre passe-bande, en particulier avec des coefficients de filtrage constants, prescrits lors du fonctionnement.

5. Procédé selon l'une des revendications précédentes, **caractérisé en ce que**
- le taux de répétition de mots du signal de sonde numérisé ou du signal de démodulation numérique se situe dans une plage de 1 kHz à 200 MHz, en particulier de 2 MHz à 6 MHz.

6. Procédé selon l'une des revendications précédentes, **caractérisé par** les étapes suivantes :
- l'application, à l'échantillon (8), d'un champ magnétique alternatif afin de générer dans l'échantillon (8) un champ magnétique alternatif actif correspondant, dans lequel le champ magnétique alternatif varie périodiquement avec au moins une fréquence porteuse prescrite de sorte que le signal de sonde (US) présente l'au moins une fréquence porteuse et est modulé concernant son amplitude et/ou sa phase en fonction de propriétés du matériau de l'échantillon, et
- la démodulation numérique du signal de sonde numérisé (USD) en ce que le signal de sonde numérisé (USD) est multiplié par un signal porteur numérisé avec l'au moins une fréquence porteuse pour générer le signal de démodulation numérisé (UM) sous la forme d'une séquence de mots numériques avec le taux de répétition de mots prescrit.

7. Dispositif pour l'exécution du procédé selon l'une des revendications 1 à 6, **caractérisé par**
- la sonde (1),
- un convertisseur analogique-numérique (3) qui est réalisé pour effectuer la conversion analogique-numérique du signal de sonde (US) pour la génération du signal de sonde numérisé,
- les n étapes de décimation en cascade (5_1 à 5_n),
- des moyens de sélection (6) qui sont réalisés pour sélectionner le signal de sortie (UA1 à UA_n) de l'une des n étapes de décimation (5_1 à 5_n) en fonction de la vitesse relative, et
- le filtre numérique (7).

8. Dispositif selon la revendication 7, **caractérisé en ce que**
- la sonde (1) est une sonde de champ magnétique, laquelle est en particulier réalisée pour détecter un champ magnétique de manière inductive ou par utilisation de l'effet de Hall.

9. Dispositif selon la revendication 7 ou 8, **caractérisé par**
- des moyens de génération de champs magnétiques, lesquels sont réalisés pour l'application du champ magnétique alternatif à l'échantillon, et
- un démodulateur numérique (4), lequel est réalisé pour la démodulation numérique du signal de sonde numérisé.
